# NEUE EUROPÄISCHE PATENTSCHRIFT

(11) **EP 3 012 688 B2**
(45) Veröffentlichungstag und Bekanntmachung des Hinweises auf die Entscheidung über den Einspruch: **08.02.2023**
(45) Hinweis auf die Patenterteilung: 02.10.2019
(21) Anmeldenummer: 15180364.0
(22) Anmeldetag: 10.08.2015
(51) Int. Cl.: G03F 7/09, G03F 7/11, G03F 7/00, B29K 105/00, B29C 35/08, B29L 29/00, G03F 7/20, B29L 9/00, B29C 64/124, B29C 64/129, B29C 64/141, B29C 64/153, B29C 64/40, B29C 64/10, B29C 64/282, B29C 64/277, B29C 33/38, B29C 64/295, B29C 64/135

(54) **VERFAHREN ZUM HERSTELLEN EINER DREIDIMENSIONALEN STRUKTUR**
METHOD FOR PRODUCING A THREE-DIMENSIONAL STRUCTURE
PROCEDE DE FABRICATION D'UNE STRUCTURE TRIDIMENSIONNELLE

(30) Priorität: 22.10.2014 DE 102014221480
(43) Veröffentlichungstag der Anmeldung: 27.04.2016
(73) Patentinhaber: Nanoscribe GmbH, 76344 Eggenstein-Leopoldshafen (DE)
(72) Erfinder: Thiel, Michael, 76137 Karlsruhe (DE); Reiner, Roman Reinhard, 76131 Karlsruhe (DE); Niesler, Fabian, 76227 Karlsruhe (DE); Tanguy, Yann, 76351 Linkenheim-Hochstetten (DE)
(74) Vertreter: DREISS Patentanwälte PartG mbB

(56) Entgegenhaltungen:
- BE-A3- 1 008 128
- US-A- 5 198 159
- MANGIRDAS MALINAUSKAS ET AL: "<title>Femtosecond laser fabrication of hybrid micro-optical elements and their integration on the fiber tip</title>", PROCEEDINGS OF SPIE, Bd. 7716, 30. April 2010 (2010-04-30), Seite 77160A, XP055241951, US ISSN: 0277-786X, DOI: 10.1117/12.854396 ISBN: 978-1-62841-730-2
- MA W ET AL: "NURBS-based adaptive slicing for efficient rapid prototyping", COMPUTER AIDED DESIGN, ELSEVIER PUBLISHERS BV., BARKING, GB, Bd. 36, Nr. 13, 1. November 2004 (2004-11-01), Seiten 1309-1325, XP004534034, ISSN: 0010-4485, DOI: 10.1016/J.CAD.2004.02.001
- ROSA L ET AL: "Optoplasmonics: hybridization in 3D", PROCEEDINGS OF SPIE, S P I E - INTERNATIONAL SOCIETY FOR OPTICAL ENGINEERING, US, Bd. 8923, 7. Dezember 2013 (2013-12-07), Seiten 89231Q-89231Q, XP060031915, ISSN: 0277-786X, DOI: 10.1117/12.2033716 ISBN: 978-1-62841-730-2
- HONG-BO SUN et al.: "Two-Photon Laser Precision Microfabrication and Its Application to Micro-Nano Devices and Systems", Journal of Lightwave Technology, vol. 21, no. 3, March 2003 (2003-03),
- TANAKA T, SUN H-B, KAWATA S: "RAPID SUB-DIFFRACTION-LIMIT LASER MICRO/NANOPROCESSING IN A THRESHOLD MATERIAL SYSTEM", Applied Physics Letters, vol. 80, no. 02, 14 January 2002 (2002-01-14), pages 312-314, US ISSN: 0003-6951, DOI: 10.1063/1.1432450
- CHAO-YAUG LIAO: "Product Model Creation and Simulation for Two-photon Polymerization Micro-manufacturing", Mechanics [physics.med-ph, 2008, Retrieved from the Internet: URL:https://tel.archives-ouvertes.fr/tel-0 0417799

## Beschreibung

Die Erfindung betrifft ein Verfahren zum Herstellen einer dreidimensionalen Struktur in einem Lithografiematerial gemäß dem Anspruch 1.

Solche lithografischen Verfahren finden z.B. bei der Herstellung von Prototypen oder bei der Erzeugung von Werkstücken mit speziellen Formanforderungen Verwendung. Insbesondere dienen derartige Verfahren auch der Erzeugung von Mikro- oder Nanostrukturen, z.B. zu experimentellen Zwecken sowie in Bereichen, in denen große Gestaltungsfreiheit erwünscht ist. Anwendungen bestehen z.B. in der Herstellung von abformbaren Topographien, Schablonen oder Matrizen für die Massenreplikation, in der Herstellung angepasster Stecker für Lichtleiter und in der Herstellung von angepassten Prothesen für medizinische Anwendungen. Das Dokument "Femtosecond laser fabrication of hybrid micro-optical elements and their integration on the fiber tip", M. Malinauskas et. al., Proceedings of SPIE, Vol. 7716, S. 77160A-1 ff. (2010) beschreibt die Herstellung von Mikrolinsen mit einem Verfahren, welches die Merkmale des Oberbegriffs des Anspruchs 1 aufweist. Bekannt sind sogenannte Stereolithografie-Verfahren (z.B. aus der US 4,575,330 A1), wobei eine gewünschte Struktur schichtweise in einem Bad aus flüssigem Lithografiematerial, insbesondere Fotopolymer, durch gezielte Belichtung mit einem Schreibstrahl aufgebaut wird. Hierzu polymerisiert der Schreibstrahl durch lokale Belichtung jeweils eine Schicht an der Oberfläche des Bades aus Lithografiematerial mit einem gewünschten Muster. Durch schrittweises Absenken eines Trägersubstrates in dem Bad aus Lithografiematerial wird dann die Struktur lagenweise aufgebaut. Hierbei ist es auch bekannt (beispielsweise aus der DE 105 07 881 B4), die lagenweise aufgebaute Struktur mit zusätzlichen Stützstrukturen zu versehen, welche ebenfalls in dem Lithografiematerial erzeugt werden und sich in der Regel außerhalb der Struktur erstrecken, um die Struktur an dem Trägersubstrat abzustützen. Durch solche Stützstrukturen wird ein Kollabieren der unfertigen Struktur vermieden.

Die genannten Verfahren erlauben zwar die Herstellung von Strukturen mit großer Gestaltungsfreiheit und hoher Präzision, können jedoch eine erhebliche Prozesszeit in Anspruch nehmen, insbesondere wenn großvolumige und zusammenhängende Strukturen erzeugt werden sollen. Dieses Problem tritt insbesondere auf, wenn die gewünschte Struktur sowohl großvolumige Abschnitte und außerdem Bereiche mit kleinen Strukturgrößen aufweist. Wenn dabei aufgrund der kleinen Strukturierung eine hohe Ortsauflösung erforderlich ist, so führt die Herstellung der großvolumigen Bereiche zu einer erheblich verlängerten Prozesszeit.

Die Aufgabe der vorliegenden Erfindung besteht darin, die Herstellung von Strukturen mit einem hohen Grad an Gestaltungsfreiheit und einer möglichst kurzen Prozesszeit zu ermöglichen und dabei eine hohe Präzision und Formtreue der erzeugten Struktur zu gewährleisten.

Diese Aufgabe wird durch ein Verfahren gemäß Anspruch 1 gelöst. Die gewünschte dreidimensionale Struktur wird in einem Lithografiematerial erzeugt, welches mittels Energieeintragsmethoden (z.B. Bestrahlung, Erwärmung) kontrolliert polymerisierbar und dadurch verfestigbar bzw. aushärtbar ist. Das Lithografiematerial liegt in seinem unpolymerisierten Zustand vorzugsweise flüssig, viskos, gelförmig oder fest vor. Beispielsweise kommt ein Lithografielack, insbesondere ein Negativlack, zum Einsatz. Gemäß dem Verfahren wird zunächst mittels einer ersten, räumlich ortsauflösenden Energieeintragsmethode eine Mantelwandung der zur erzeugenden Struktur derart definiert (d.h. in dem Lithografiematerial ortsaufgelöst polymerisiert), dass durch die Mantelwandung ein Volumen an unpolymerisiertem Lithografiematerial eingeschlossen ist. Daraufhin wird ein Zwischenentwicklungsschritt durchgeführt, in welchem das die polymerisierte Mantelwandung umgebende Lithografiematerial zumindest teilweise entfernt wird. Hierauf folgend wird mittels einer zweiten Energieeintragsmethode das mittels der Mantelwandung eingeschlossene Volumen an Lithografiematerial polymerisiert, d.h. verfestigt bzw. ausgehärtet.

Insofern wird in dem unpolymerisierten Ausgangszustand des Lithografiematerials zunächst ein Volumen an Lithografiematerial gegenüber dem umgebenden Lithografiematerial durch die Mantelwandung abgegrenzt. Hierzu wird eine Energieeintragsmethode gewählt, mittels welcher die Mantelwandung mit der erforderlichen Ortsauflösung erzeugbar ist. Durch die Mantelwandung ist die gewünschte Struktur in dem umgebenden Lithografiematerial definiert. In dem Zwischenentwicklungsschritt wird das umgebende Lithografiematerial zumindest teilweise, vorzugsweise vollständig, entfernt.

Insofern wird mit der hohen Ortsauflösung der ersten Methode die Mantelwandung geschrieben. Bei der Polymerisierung und Verfestigung des eingeschlossenen Lithografiematerials kann dann der Energieeintrag ohne eine hohe Ortsauflösung erfolgen. Dadurch kann erheblich Prozesszeit eingespart werden. Insbesondere ist es nicht erforderlich, großvolumige Abschnitte in zeitaufwändiger Weise mit der ortsauflösenden Energieeintragsmethode zu schreiben. Die Abmessungen der erzeugten Strukturmerkmale (Wandungen, Stützstrukturen usw.) können beispielsweise auf der Nanoskala (<10e-1 µm), Mikroskala (10e-1-10e+2 pm) und auf der Mesoskala (10e+2 - 10e+4 pm) liegen. Die erzeugten Volumina sind zwar grundsätzlich nicht beschränkt, können bei typischen Anwendungen aber im Bereich < 1 Kubikzentimeter liegen.

Bei dem erfindungsgemäßen Verfahren wird trotz der deutlich verkürzten Prozesszeit eine hohe Ortsauflösung gewährleistet, da die einhüllende Mantelwandung mit der ortsauflösenden ersten Energieeintragsmethode erzeugt wird. Dadurch wird ein Rapid Prototyping mit kürzeren Prozesszeiten möglich.

Mittels der ersten, ortsauflösenden Energieeintragsmethode wird - vorzugsweise gemeinsam mit der Mantelwandung - eine innerhalb der Mantelwandung liegende Stützstruktur definiert, d.h. auspolymerisiert. Die Stützstruktur liegt insofern insbesondere innerhalb des durch die Mantelwandung eingeschlossenen Volumens und kann dieses ggf. auch in Teilvolumina unterteilen. Bei der Definition Stützstruktur kann auch ein geringfügiger Überlapp mit der Mantelwandung vorteilhaft sein, so dass Elemente der Stützstruktur geringfügig mit der Mantelwandung überlappen und so mit dieser fest verbunden sind. Die Stützstruktur weist insbesondere Stützelemente auf, welche sich zwischen Abschnitten der Mantelwandung und/oder zwischen Abschnitten der Mantelwandung und einem Substrat erstrecken. Durch die Stützstruktur kann die Formtreue der durch die Mantelwandung vorgegebenen Form gewahrt werden. Insbesondere kann verhindert werden, dass die durch die Mantelwandung definierte Struktur bei dem Zwischenentwicklungsschritt, während der zweiten Energieeintragsmethode oder einem Curing-Schritt verformt wird oder kollabiert. Insgesamt kann sichergestellt werden, dass nach Aushärtung des eingeschlossenen Volumens die erzielte Form mit der durch die Mantelwandung vorgegebenen Form übereinstimmt.

Anders als bei bekannten Strukturierungsverfahren mit außenliegenden Stützstrukturen muss eine innen liegende Stützstruktur nach Fertigstellung der gewünschten Struktur nicht entfernt werden. So kann Prozesszeit zur Nachbearbeitung (Finishing) der Struktur nach Aushärten des inneren Volumens eingespart werden. Darüber hinaus bildet eine außenliegende Stützstruktur nach ihrer Entfernung in der Regel ein Abfallprodukt, was bei Verwendung von teuren Lithografiematerialien zu unerwünschten Kostenerhöhungen führen kann und durch die innen liegende Stützstruktur vermieden wird.

Die Gestaltung der Stützstruktur erlaubt es außerdem, die mechanischen Eigenschaften der gewünschten Struktur einzustellen und zu beeinflussen. So kann beispielsweise durch geeignete Stützstrukturen ein federnder Kern in der Mantelwandung erzeugt werden. Denkbar ist, die Elastizität der gewünschten Struktur zu beeinflussen. Die Stützstruktur kann beispielsweise fachwerkartig, in der Art eines 3D-Wabengitters, als kubisches Gitter und/oder als Anordnung aus sich zwischen Abschnitten der Mantelwandung erstreckenden Streben oder Wandungen ausgestaltet sein. Grundsätzlich ist es denkbar, dass das eingeschlossene Volumen nach dem zweiten Energieeintragsprozess einen anderen Polymerisierungsgrad und/oder andere mechanische Eigenschaften und/oder andere optische Eigenschaften aufweist, als die umgebende Mantelwandung. Hierdurch können Strukturen mit verschiedenen mechanischen oder optischen Eigenschaften erzeugt werden. Außerdem ist eine außenliegende Stützstruktur nicht zwingend erforderlich. Solche außenliegenden Stützstrukturen haben bei den eingangs erläuterten Verfahren zum schichtweisen Aufbauen von Strukturen in dem Lithografiematerial u.a. die Funktion, die lageweise entstehende Struktur in dem Bad aus Lithografiematerial zu fixieren und ein Wegschwimmen von Abschnitten der unfertigen Struktur zu verhindern, was bei Aufbau einer Mantelschale unterbunden wird.

Die zweite Energieeintragsmethode ist verschieden von der ersten Energieeintragsmethode. Insbesondere kann die zweite Energieeintragsmethode als nicht ortsauflösende Methode ausgestaltet sein und/oder auf das gesamte von der Mantelwandung eingeschlossene unpolymerisierte Lithografiematerial wirken. Insofern kann die erste Energieeintragsmethode eine Ortsauflösung aufweisen, welche um ein Vielfaches höher ist, als die Ortsauflösung der zweiten Energieeintragsmethode. Beispielsweise kann die zweite Energieeintragsmethode ein Erwärmungsverfahren, ein Baking-Verfahren oder ein anderes Curing-Verfahren sein. Beispielsweise kann die Struktur mit der polymerisierten Mantelwandung in einen Ofen, z.B. Konvektionsofen oder Röhrenofen, gebracht werden oder Kontakt mit einer Heizeinrichtung (z.B. Heizplatte) hergestellt werden. Denkbar ist auch eine Energieeintragsmethode unter Ausnutzung von Mikrowellenbestrahlung, Infrarotbestrahlung, UV-Bestrahlung.

Demgegenüber erfolgt bei der ersten, ortsauflösenden Energieeintragsmethode die Polymerisation des Lithografiematerials vorzugsweise in einem räumlich eng begrenzten und insbesondere verlagerbaren Fokusbereichs eines Schreibstrahls einer Strahlungsquelle. Denkbar ist auch eine Parallelisierung des Verfahrens, wobei ein oder mehrere Fokusbereiche mehrerer Schreibstrahle mehrerer Strahlungsquellen verwendet werden, die ein ortsaufgelöstes Belichtungsmuster bilden können. Die erste Energieeintragsmethode kann z.B. eine Laserlithografiemethode oder Elektronenstrahllithografiemethode sein, insbesondere eine 3D-Laserlithografiemethode. Die Definition der Struktur mit einem Schreibstrahl ist zwar zeitaufwändig, jedoch lassen sich hochpräzise Strukturen erzielen. Da nur die Mantelwandung definiert wird, kann jedoch trotzdem eine kurze Strukturierungszeit erzielt werden.

Bei der ersten Energieeintragsmethode erfolgt die Polymerisation des Lithografiematerials durch Zwei-Photonen-Absorption oder Multi-Photonen-Absorption in dem Fokusbereich des Schreibstrahls. Das Lithografiematerial ist insbesondere derart ausgebildet und die Strahlungsquelle insbesondere derart auf das Lithografiematerial abgestimmt, dass eine Polymerisation nur mittels Zwei-Photonen-Absorption oder Multi-Photonen-Absorption möglich ist. Hierzu kann beispielsweise die Wellenlänge des Schreibstrahls so groß gewählt sein (und damit die Photonenenergie so niedrig sein), dass der für die Polymerisation erforderliche Energieeintrag nur durch gleichzeitige Absorption zweier oder mehrerer Photonen erreicht wird. Die Wahrscheinlichkeit für einen solchen Absorptionsprozess ist intensitätsabhängig und im Vergleich zum übrigen Schreibstrahl in dem Fokusbereich deutlich erhöht. Im Rahmen von grundsätzlichen Überlegungen ergibt sich, dass die Wahrscheinlichkeit zur Absorption von zwei oder mehreren Photonen vom Quadrat oder einer höheren Potenz der Strahlungsintensität abhängen kann. Im Gegensatz hierzu weist die Wahrscheinlichkeit für die Absorption eines Photons eine andere Intensitätsabhängigkeit auf. Beim Eindringen des Schreibstrahls in das Lithografiematerial erfolgt außerdem grundsätzlich eine Dämpfung. So kann beispielsweise das Beer'sche Gesetz für die Intensitätsabnahme in Abhängigkeit der Eindringtiefe in das Lithografiematerial gelten. Dies führt dazu, dass eine ortsauflösende Polymerisation in einem Fokusbereich tief unter der Oberfläche des Lithografiematerials unter Ausnutzung einer Ein-Photonen-Absorption problematisch wäre, da aufgrund der Dämpfung bei Fokussierung unterhalb der Oberfläche im Fokusbereich nicht zwingend die höchste Intensität vorliegt. Bei den eingangs beschriebenen Stereolithografiemethoden erfolgt daher der Aufbau der Struktur schichtweise stets nur durch Belichtung des Lithografiematerials an der Oberfläche eines Bades aus Lithografiematerial. Bei Ausnutzung der Zwei-Photonen-Absorption oder der Multi-Photonen-Absorption ist dieses lageweise Absenken der Struktur in ein Bad aus Lithografiematerial nicht zwingend nötig, da die Polymerisation auch bei größerer Eindringtiefe aufgrund der anderen Gesetzmäßigkeiten auf den Fokusbereich des Schreibstrahls beschränkt sein kann.

Vorzugsweise ist die Mantelwandung eine ein Volumen vollständig umschließende Mantelwandung. Denkbar ist jedoch auch, dass das Lithografiematerial auf einem Substrat aufgebracht ist und ein Abschnitt einer Oberfläche des Substrates zusammen mit der Mantelwandung das Volumen an unpolymerisiertem Lithografiematerial einschließt. Das Substrat kann grundsätzlich beliebig sein, z.B. ein Glas- oder Halbleiterwafer, ein Keramikteil oder ein Formkörper. Die Oberfläche des Substrates dient insofern als Teil der Begrenzung des eingeschlossenen Volumens. Dadurch muss die Mantelwandung das Volumen nicht vollständig einschließen und muss in dem ersten Energieeintragsschritt nicht erzeugt werden. Dies bringt eine weitere Zeitersparnis mit sich, da ein Abschluss des eingeschlossenen Volumens teilweise von dem Substrat gebildet ist.

Der Zwischenentwicklungsschritt ist vorzugsweise derart ausgestaltet, dass das durch die Mantelwandung eingeschlossene Volumen an unpolymerisiertem Lithografiematerial weitgehend unbeeinflusst bleibt, insbesondere ungehärtet und/oder unangelöst bleibt. Der Zwischenentwicklungsschritt kann beispielsweise ein nasschemischer Entwicklungsschritt sein und insbesondere dazu ausgestaltet sein, ein Ablösen des die Mantelschale umgebenden Lithografiematerials zu bewirken. Denkbar ist beispielsweise ein Bad in einem Entwicklermedium.

Vorzugsweise wird ein Lithografiematerial verwendet, welches photopolymerisierbar und thermopolymerisierbar ist. Insofern wird unter einem photopolymerisierbaren Material beispielsweise ein lichtaushärtender Kunststoff verstanden, welcher mit der ersten Energieeintragsmethode z.B. mittels eines Schreibstrahls aus Licht, Laserlicht, UV oder Ähnlichem polymerisierbar ist. Ein thermopolymerisierbares Lithografiematerial ist beispielsweise ein Material, welches bei Erwärmung über einer Schwelltemperatur eine Umwandlung in den polymerisierten Zustand vollzieht. Die zweite Energieeintragsmethode ist dann vorzugsweise ein Erwärmen. Denkbar ist jedoch auch die Verwendung eines nur photopolymerisierbaren Materials, wobei die erste Energieeintragsmethode ein ortsaufgelöstes Bestrahlen ist und die zweite Energieeintragsmethode eine großvolumige Bestrahlung umfasst, beispielsweise ein UV-Curing.

Die Materialwandung kann mit Wandungsabschnitten ausgestaltet sein, die jeweils verschiedene Wandungsdicken aufweisen. Dadurch können mechanische Eigenschaften der Materialwandung eingestellt werden. Denkbar ist außerdem, dass nur solche Wandungsabschnitte mit einer großen Wanddicke ausgestaltet werden, welche aufgrund der Strukturform eine hohe Stabilität aufweisen müssen, beispielsweise um ein Kollabieren der Mantelwandung bei dem Zwischenentwicklungsschritt zu vermeiden.

Zur weiteren Ausgestaltung des Verfahrens ist denkbar, dass nach dem Zwischenentwicklungsschritt ein Nachhärten der Mantelwandung erfolgt und/oder nach der Polymerisation mit der zweiten Energieeintragsmethode ein Nachhärten der erzielten Struktur erfolgt. Das Nachhärten kann beispielsweise ein Curing-Schritt und/oder eine chemische Behandlung in einem Härter-Bad umfassen.

Grundsätzlich kann ein vorgeschalteter softwaretechnischer Datenverarbeitungs-Prozess vorgesehen sein, bei dem zunächst die zu erzeugende Struktur repräsentierende Daten bereitgestellt werden (z.B. CAD-Daten), und dann ein wenigstens einer Mantelschale zugeordneter Datensatz softwaretechnisch ermittelt wird, so dass die Mantelschale und das eingeschlossene Volumen zusammen die gewünschte Struktur ergeben. Eine Einrichtung zur Durchführung der ersten Energieeintragsmethode (z.B. ein 3D-Laser-Lithograf) kann dann mit dem Datensatz entsprechend angesteuert werden.

Bei Strukturen mit großvolumigen Abschnitten kann die Mantelwandung auch sequentiell aus Teilwandungen zusammengesetzt werden. Hierzu wird die Mantelwandung dadurch definiert, dass sequentiell eine Mehrzahl von Teilwandungen erzeugt werden, wobei zum Schreiben der Teilwandungen ein Schreibbereich einer Einrichtung zur Durchführung der ortsauflösenden Energieeintragsmethode sequentiell verlagert und positioniert wird, und wobei jeweils in dem Schreibbereich eine Teilwandung definiert wird, d.h. auspolymerisiert wird.

Hierzu kann zunächst in einem Datenverarbeitungsschritt die die Struktur repräsentierenden Daten softwaretechnisch in die den Teilwandungen zugeordneten Teilbereiche zerlegt werden, beispielsweise in einem sogenannten Splitting-Verfahren. Die Einrichtung zur Durchführung der ortsauflösenden Energieeintragsmethode (z.B. 3D-Laser-Lithograf) kann dann entsprechend angesteuert werden.

Grundsätzlich ist der Schreibbereich durch die technischen Gegebenheiten der Energieeintragseinrichtung oder Belichtungseinrichtung vorgegeben und umfasst insbesondere denjenigen Bereich, in welchen der Schreibstrahl mit der erforderlichen Ortsauflösung gelenkt werden kann. Die Erzeugung der Mantelwandung aus zusammengesetzten Teilwandungen ist insbesondere dann vorteilhaft, wenn die ortsauflösende Energieeintragsmethode mittels einer Einrichtung vorgenommen wird, welche einen im Vergleich zur Größe der zu erzeugenden Struktur kleinen Schreibbereich aufweist.

Die Erfindung wird im Folgenden anhand der Figuren näher erläutert.

Es zeigen:
Figur 1 Skizzierte Darstellung einer herzustellenden Struktur zur Erläuterung des Herstellungsverfahrens;
Figuren 2 bis 4 Skizzierte Darstellungen zur Veranschaulichung der Herstellungsschritte für die Struktur gemäß Figur 1;
Figur 5 Skizzierte Darstellung zur Erläuterung des Herstellungsverfahrens für eine Struktur mit anderen Gestaltungsmerkmalen;
Figur 6 Skizzierte Darstellung zur Erläuterung eines Zwischenschritts der Herstellung der Struktur gemäß Figur 5;
Figur 7 Skizzierte Darstellung zur Erläuterung des Herstellungsverfahrens für eine komplexere Struktur.

In der nachfolgenden Beschreibung sowie in den Figuren sind für identische oder einander entsprechende Merkmale jeweils dieselben Bezugszeichen verwendet.

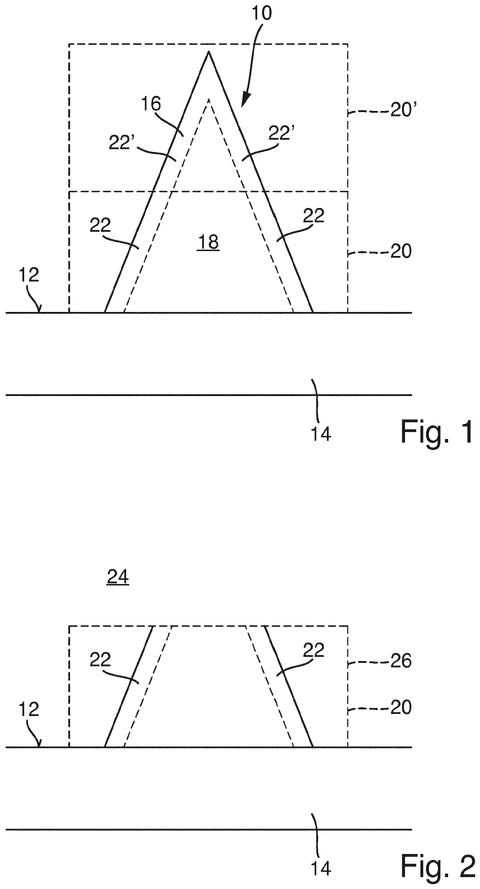

Anhand der Figuren 1 bis 4 wird zunächst der Aufbau einer ersten beispielhaften dreidimensionalen Struktur schematisch beschrieben.

Hierzu werden zunächst softwaretechnisch Daten bereitgestellt (z.B. CAD-Daten), welche eine herzustellende Struktur 10 repräsentieren. Beispielhaft ist hier eine pyramidale Struktur 10 gewählt, die auf einer Oberfläche 12 eines Substrates 14 im Wege eines dreidimensionalen Prototyping-Verfahrens hergestellt werden soll. Hierzu werden die die Struktur 10 repräsentierenden Daten softwaretechnisch in eine Mantelwandung 16 und in einen innerhalb der Mantelwandung 16 liegenden Volumenabschnitt 18 der Struktur 10 zerlegt. Im dargestellten Beispiel wird der Volumenabschnitt 18 einerseits von der Mantelwandung 16 nach außen hin begrenzt, andererseits durch die Oberfläche 12 des Substrats 14 abgeschlossen. Denkbar sind jedoch auch Strukturen 10, die in sämtliche Richtungen durch eine Mantelwandung 16 begrenzt sind und/oder nicht auf einem Substrat angeordnet sind.

Softwaretechnisch erfolgt ferner eine Zerlegung der Struktur 10 in Teilbereiche 20, 20', welche unmittelbar aneinander angrenzen und die Struktur 10 insbesondere vollständig und z.B. überlappungsfrei überdecken. Je nach Anwendung und/oder Präzision der verwendeten Instrumente kann jedoch auch ein geringfügiger Überlapp vorteilhaft sein. In jedem Teilbereich 20, 20' sind Teilwandungen 22, 22' der Mantelwandung 16 umfasst, derart, dass sich bei Zusammensetzen der Teilbereiche 20, 20' die Teilwandungen 22, 22' zu der vollständigen Mantelwandung 16 (insbesondere überlappungsfrei) ergänzen.

Anhand der Figuren 2 bis 4 wird im Folgenden beschrieben, wie die durch die Daten in der Art der Figur 1 repräsentierte Struktur 10 tatsächlich hergestellt wird. Hierzu wird das Substrat 14 beispielsweise in ein Bad aus einem Lithografiematerial 24 angeordnet, welches insofern den Raum oberhalb der Oberfläche 12 des Substrates 14 ausfüllt (vgl. Figur 2). Das Lithografiematerial 24 ist beispielsweise ein flüssiger oder viskoser Kunststofflack, welcher sowohl photopolymerisierbar, als auch thermopolymerisierbar ist. Insofern kann das Lithografiematerial 24 durch Energieeintragsmethoden kontrolliert polymerisiert und dadurch verfestigt werden. Zur Photopolymerisation findet beispielsweise eine erste, räumlich ortsauflösende Energieeintragsmethode Verwendung, bei welcher in einem Fokusbereich eines Schreibstrahls räumlich ortsauflösend Polymerisation hervorgerufen werden kann. Mittels einer zweiten Energieeintragsmethode kann außerdem z.B. die Thermopolymerisation erfolgen, wie nachfolgend noch näher erläutert.

Zur Herstellung der Struktur 10 wird zunächst mit der räumlich ortsauflösenden ersten Energieeintragsmethode (z.B. Photopolymerisation in einem räumlich verlagerbaren Fokusbereich eines Schreibstrahls) nur die Mantelwandung 16 in dem Lithografiematerial 24 polymerisiert, verfestigt.

Da bei Einrichtungen zur Erzeugung eines räumlich ortsaufgelösten Energieeintrags oftmals der Schreibbereich aufgrund der Präzisionsanforderungen beschränkt ist, werden die Strukturdetails in den Teilbereichen 20, 20' nacheinander geschrieben. Insbesondere sind die Teilbereiche 20, 20' derart gewählt, dass sie jeweils innerhalb eines Schreibbereiches 26 der Einrichtung für den ersten, ortsauflösenden Energieeintrag (z.B. Laser-Lithograf) liegen.

Wie in Figur 2 dargestellt, wird daher zunächst der Schreibbereich 26 für die erste, auflösende Energieeintragsmethode auf den ersten Teilbereich 20 der Struktur 10 gelegt und die Teilwandungen 22 des ersten Teilbereichs 20 geschrieben. Im folgenden Schritt wird der Schreibbereich 26 über den weiteren Teilbereich 20' der Struktur 10 gelegt und die Teilwandungen 22' geschrieben, d.h. auspolymerisiert und verfestigt. Die Teilwandungen 22, 22' setzen sich vollständig zu der Mantelwandung 16 zusammen. Dadurch wird durch die Mantelwandung 16 und im dargestellten Beispiel auch durch die Oberfläche 12 des Substrates 14 ein Volumen 28 an noch unpolymerisiertem Lithografiematerial eingeschlossen. Dies ist darauf zurückzuführen, dass die gewählte erste Energieantragsmethode zur Erzeugung der Mantelwandung 16 eine hohe Ortsauflösung aufweist und kontrolliert nur die Mantelwandung 16 polymerisiert. Das eingeschlossene Volumen 28 korrespondiert mit dem Volumenabschnitt 18 der Struktur 10.

Um das eingeschlossene Volumen 28 ebenfalls zu verfestigen und so die Struktur 10 dauerhaft zu erzeugen, kann in einem Zwischenentwicklungsschritt das die Mantelwandung 16 umgebende Lithografiematerial entfernt werden, beispielsweise in einem Bad aus Entwicklermedium.

Die so freigelegte Struktur aus Mantelwandung 16 und eingeschlossenem, noch nicht polymerisierten Volumen 28 an Lithografiematerial kann dann eine Einrichtung zur Erzeugung einer zweiten Energieeintragsmethode verbracht werden. Die zweite Energieeintragsmethode muss keine hohe Ortsauflösung mehr aufweisen. Vielmehr ist denkbar, dass die zweite Energieeintragsmethode global auf die gesamte, von der Mantelwandung 16 eingeschlossene Struktur wirkt. Beispielsweise kann das Substrat 14 mit der Mantelwandung 16 und dem eingeschlossenen Volumen 28 in einen Ofen zur Erwärmung gebracht werden. Durch den Energieeintrag mit der zweiten Energieeintragsmethode wird dann das eingeschlossene Volumen 28 ebenfalls polymerisiert und verfestigt.

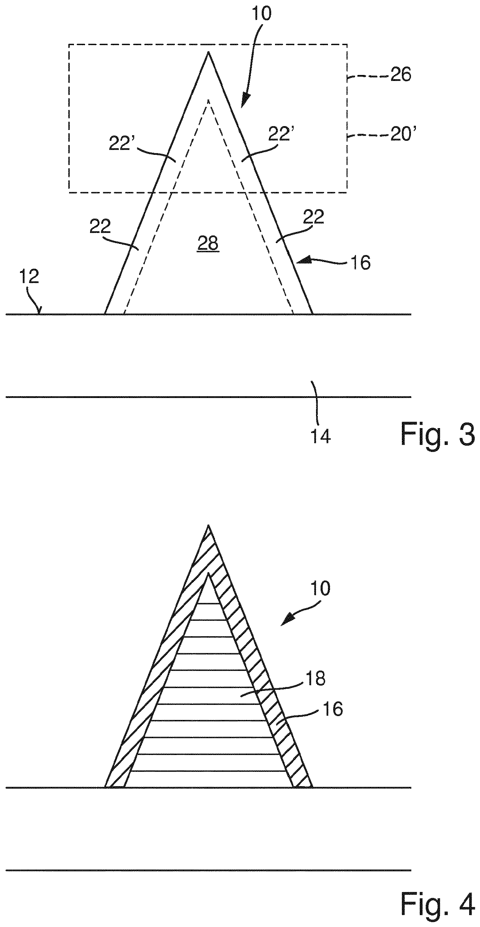

Wie in Figur 4 veranschaulicht, kann durch die Ausgestaltung der zweiten Energieeintragsmethode die Charakteristik der Aushärtung des Volumens 28 beeinflusst werden und so ein Volumenabschnitt 18 im Innern der Mantelwandung 16 erzeugt werden, wobei beispielsweise die physikalischen Eigenschaften des Volumenabschnitts 18 von der Mantelwandung 16 abweichen. Denkbar ist jedoch auch, dass die zweite Energieeintragsmethode derart ausgestaltet ist, dass nach Aushärtung des Volumens 28 eine homogene Struktur 10 entsteht, welche sich aus der Mantelwandung 16 und dem darin eingeschlossenen Volumenabschnitt 18 zusammensetzt, wobei die Mantelwandung 16 und Volumenabschnitt 18 gleiche Struktureigenschaften und/oder physikalische Eigenschaften aufweisen.

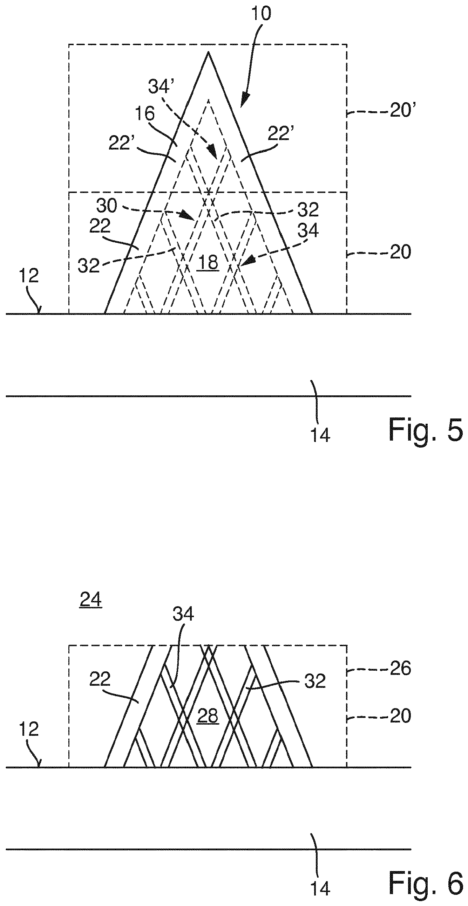

Anhand der Figuren 5 und 6 wird eine weitere Ausgestaltung des Herstellungsverfahrens erläutert. In der Figur 5 wird wiederum die Aufbereitung der die gewünschte Struktur 10 repräsentierenden Daten veranschaulicht. Die Struktur 10 wird wiederum eine Mantelwandung 16 und einen eingeschlossenen Volumenabschnitt 18 zerlegt. Ferner wird eine innerhalb der Mantelwandung 16 liegende Stützstruktur 30 definiert, welche eine Mehrzahl von Stützelementen 32 aufweist. Im dargestellten Beispiel erstrecken sich die Stützelemente 32 zwischen Abschnitten der Mantelwandung 16 und der Oberfläche 12 des Substrates 14. Es können jedoch auch zusätzlich oder alternativ hierzu Stützelemente vorgesehen sein, welche sich ausschließlich zwischen Abschnitten der Mantelwandung erstrecken. Dies kommt insbesondere dann in Betracht, wenn der Volumenabschnitt nur von Mantelwandungen 16 eingeschlossen ist, und keine Begrenzung des Volumenabschnitts 18 durch die Oberfläche 12 des Substrates 14 erfolgt.

Um einer beschränkten Größe eines Schreibbereiches für die erste Energieeintragsmethode gerecht zu werden, kann die Struktur 10 wiederum in mehrere Teilbereiche 20, 20' zerlegt werden, welche wiederum jeweils Teilwandungen 22, 22' umfassen, die sich zu der Mantelwandung 16 zusammensetzen. In den Teilbereichen 20, 20' sind dann auch Teilabschnitte 34, 34' der Stützstruktur 30 enthalten, so dass durch Zusammensetzen der Teilbereiche 20, 20' die gesamte Stützstruktur 30 entsteht.

Anhand von Figur 6 wird wiederum der tatsächliche Aufbau der Struktur 10 erläutert, wozu beispielhaft das Substrat 14 in ein Bad aus Lithografiematerial 24 eingebracht wird. In einem ersten Schritt wird der Schreibbereich 26 über den ersten Teilbereich 20 der Struktur 10 gelegt und mit der ortsauflösenden ersten Energieeintragsmethode die Teilwandungen 22 der Mantelwandung 16 und die Teilabschnitte 34 der Stützstruktur 30 polymerisiert. In einem folgenden Schritt wird der Schreibbereich 26 über den weiteren Teilbereich 20' der Struktur 10 gelegt und die übrigen Teilwandungen und Teilabschnitte der Stützstruktur geschrieben. Dadurch wird innerhalb der Mantelwandung 16 und ggf. der Oberfläche 12 des Substrats 14 ein Volumen 28 an unpolymerisiertem Lithografiematerial 24 eingeschlossen. In diesem Fall ist das unpolymerisierte Volumen 28 von den verfestigten Stützelementen 32 der Stützstruktur 30 durchsetzt. Da sich die Stützelemente 32 im dargestellten Beispiel zwischen Abschnitten der Mantelwandung 16 und der Substratoberfläche 12 erstrecken, verhindern die Stützelemente 32 ein Kollabieren der Mantelwandung 16, beispielsweise in einem folgenden Zwischenentwicklungsschritt. Bei alternativen Ausgestaltungen können Stützelemente 32, welche sich zwischen Abschnitten der Mantelwandung 16 erstrecken, ein Verformen oder Wegschwimmen von Bereichen der Mantelwandung 16 vermeiden.

In darauffolgenden Verfahrensschritten wird wiederum mit einer zweiten Energieeintragsmethode, welche keine präzise Ortsauflösung aufweisen muss, das eingeschlossene Volumen 28 polymerisiert. Je nach Bedarf kann vorher Material in einem Zwischenentwicklungsschritt entfernt werden. Durch Einstellung der Parameter für die zweite Energieeintragsmethode kann beispielsweise das Volumen 28 auch nach Polymerisation andere physikalische und/oder mechanische Eigenschaften aufweisen, als die Stützstruktur 30. So können die mechanischen Eigenschaften der Struktur 10 eingestellt werden. Denkbar ist jedoch auch, dass die zweite Energieeintragsmethode derart gewählt ist, dass im Innern der Mantelwandung eine vollständig homogene Struktur entsteht.

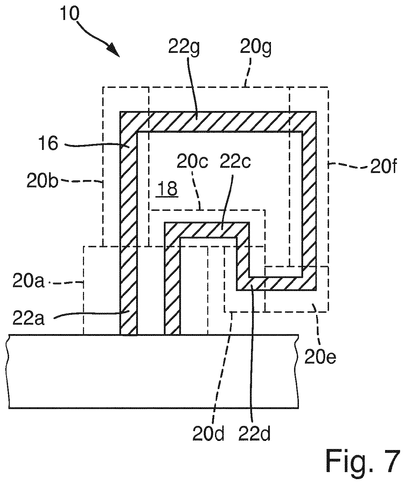

Anhand von Figur 7 wird für eine komplexere Struktur 10 die Aufbereitung der die Struktur repräsentierenden Daten zur Durchführung des Herstellungsverfahrens beschrieben. Die Struktur 10 wird wiederum in eine Mantelwandung 16 und einen hiervon eingeschlossenen Volumenabschnitt 18 zerlegt. Darüber hinaus erfolgt die Zerlegung in eine Mehrzahl von Teilbereichen 20a, 20b, 20c, 20d, 20e, 20f, 20g. Diese Teilbereiche 20a bis 20g enthalten jeweils wiederum Teilwandungen 22a, 22b, ..., von denen aus Gründen der Übersichtlichkeit nur einige exemplarisch mit separaten Bezugszeichen versehen sind. Zusätzlich ist denkbar, dass die Teilbereiche 20a bis 20g Stützstrukturen mit sich zwischen Abschnitten der Mantelwandung 16 erstreckenden Stützelementen und/oder mit sich zwischen Abschnitten der Mantelwandung 16 und einer Substratoberfläche 12 erstreckten Stützelementen enthalten (nicht dargestellt).

Zur Herstellung der Struktur 10 werden wiederum die Teilbereiche 20a bis 20g sequentiell nacheinander geschrieben und die hierin enthaltenen Teilwandungen 22 und ggf. Stützelemente oder Abschnitte der Stützstruktur geschrieben. Hierbei kann die Reihenfolge der Abarbeitung der Teilbereiche insbesondere derart erfolgen, dass eine Verformung oder Lageveränderung von bereits geschriebenen Abschnitten während des Schreibens eines folgenden Teilbereiches verhindert wird. Im dargestellten Beispiel werden vorzugsweise die Teilbereiche 20a, 20b, 20c, 20d, 20e, 20f, 20g in der wiedergegebenen Reihenfolge geschrieben. Dadurch kann beispielsweise verhindert werden, dass ein vorher geschriebener Teilbereich 20g mit der darin verfestigten Teilwandung 22g noch nicht durch andere Teilwandungen abgestützt ist und in dem Bad aus Lithografiematerial absinkt. Denkbar ist außerdem, dass die Mantelwandung 16 in den verschiedenen Teilbereichen 20a bis 20g Wandungsabschnitte mit unterschiedlichen Wandungsdicken aufweist. Beispielsweise können Teilwandungen in Teilbereichen dicker ausgeführt werden, welche eine größere Traglast von der Struktur 10 aufnehmen müssen (beispielsweise die Teilwandungen 22d und 22c in den Teilbereichen 20d und 20c).

## Patentansprüche

1. Verfahren zum Herstellen einer dreidimensionalen Struktur (10) in einem mittels Energieeintragsmethoden polymerisierbaren und dadurch verfestigbaren Lithografiematerial (24), wobei zunächst mittels einer ersten, räumlich ortsauflösenden Energieeintragsmethode eine Mantelwandung (16) der zu erzeugenden Struktur (10) derart polymerisiert wird, dass ein Volumen (28) an unpolymerisiertem Lithografiematerial eingeschlossen ist, wobei in einem Zwischenentwicklungsschritt die polymerisierte Mantelschale (16) umgebendes Lithografiematerial (24) entfernt wird, wobei danach mittels einer zweiten Energieeintragsmethode das durch die Mantelschale (16) eingeschlossene Volumen (28) polymerisiert wird, wobei mittels der ersten, ortsauflösenden Energieeintragsmethode außerdem eine Stützstruktur (30) definiert wird, welche innerhalb des durch die Mantelwandung (16) eingeschlossenen Volumens (28) liegt, **dadurch gekennzeichnet, dass** bei der ersten, ortsauflösenden Energieeintragsmethode die Polymerisation des Lithografiematerials durch Zwei-Photonen-Absorption oder Multi-Photonen-Absorption in einem räumlich verlagerbaren Fokusbereich eines Schreibstrahls einer Strahlungsquelle erfolgt und wobei die zweite Energieeintragsmethode verschieden von der ersten Energieeintragsmethode ist.

2. Verfahren nach Anspruch 1, **dadurch gekennzeichnet, dass** die zweite Energieeintragsmethode nicht ortsauflösend ist und/oder auf das von der Mantelwandung (16) eingeschlossene unpolymerisierte Lithografiematerial insgesamt wirkt.

3. Verfahren nach einem der vorherigen Ansprüche, **dadurch gekennzeichnet, dass** die innerhalb der Mantelwandung (16) liegende Stützstruktur (30) derart definiert wird, dass die Stützstruktur (30) sich zwischen Abschnitten der Mantelwandung (16) erstreckende Stützelemente aufweist.

4. Verfahren nach einem der vorherigen Ansprüche, **dadurch gekennzeichnet, dass** das Lithografiematerial auf einem Substrat (14) aufgebracht ist und ein Abschnitt einer Oberfläche (12) des Substrates (14) zusammen mit der Mantelwandung (16) das Volumen (28) an unpolymerisiertem Lithografiematerial einschließt.

5. Verfahren nach einem der vorherigen Ansprüche, **dadurch gekennzeichnet, dass** der Zwischenentwicklungsschritt das durch die Mantelwandung (16) eingeschlossene Volumen (28) an unpolymerisiertem Lithografiematerial unbeeinflusst lässt.

6. Verfahren nach einem der vorherigen Ansprüche, **dadurch gekennzeichnet, dass** ein Lithografiematerial (24) verwendet wird, welches fotopolymerisierbar oder fotopolymerisierbar und thermopolymerisierbar ist.

7. Verfahren nach einem der vorherigen Ansprüche, **dadurch gekennzeichnet, dass** die Mantelwandung (16) mehrere Wandungsabschnitte (22a-22g) mit verschiedenen Wandungsdicken aufweist.

8. Verfahren nach einem der vorherigen Ansprüche, **dadurch gekennzeichnet, dass** die Mantelwandung (16) der zu erzeugenden Struktur (10) dadurch definiert wird, dass sequentiell eine Mehrzahl von Teilwandungen (22, 22'; 22a-22g) erzeugt werden, wobei zum Definieren der Teilwandungen (22, 22'; 22a-22g) ein Schreibbereich (26) sequentiell verlagert und positioniert wird, und wobei jeweils in dem Schreibbereich (26) eine Teilwandung (22, 22'; 22a-22g) definiert wird.

## Claims

1. A method for producing a three-dimensional structure (10) in a lithographic material (24) that can be polymerized and thus solidified using energy input methods, wherein initially a shell wall (16) of the structure (10) to be produced is polymerized using a first spatially resolving energy input method such that a volume (28) of unpolymerized lithographic material is enclosed, wherein lithographic material (24) surrounding the polymerized shell wall (16) is removed in an intermediate development step, wherein subsequently the volume (28) enclosed by the shell wall (16) is polymerized using a second energy input method, wherein using the first, spatially resolving energy input method also a support structure (30) is defined, which is located within the volume (28) enclosed by the shell wall (16), **characterized in that** in the first, spatially resolving energy input method the polymerization of the lithographic material is achieved by two-photon absorption or multi-photon absorption in a spatially movable focal area of a writing beam of a radiation source and wherein the second energy input method is different from the first energy input method.

2. The method according to claim 1, **characterized in that** the second energy input method is without spatial resolution and/or acts on the entire unpolymerized lithographic material enclosed in the shell wall (16).

3. The method according to any one of the preceding claims, **characterized in that** the support structure (30) located within the shell wall (16) is defined in such a way that it includes support elements that extend between sections of the shell wall (16).

4. The method according to any one of the preceding claims, **characterized in that** the lithographic material is deposited on a substrate (14) and that a section of the surface (12) of the substrate (14) encloses the volume (28) of unpolymerized lithographic material together with the shell wall (16).

5. The method according to any one of the preceding claims, **characterized in that** the intermediate development step leaves the volume (28) of unpolymerized lithographic material enclosed in the shell wall (16) unaffected.

6. The method according to any one of the preceding claims, **characterized in that** a lithographic material (24) is used that can be photopolymerized or photopolymerized and thermopolymerized.

7. The method according to any one of the preceding claims, **characterized in that** the shell wall (16) includes several wall sections (22a-22g) with different wall thicknesses.

8. The method according to any one of the preceding claims, **characterized in that** the shell wall (16) of the structure (10) to be produced is defined by sequentially producing a plurality of partial walls (22, 22'; 22a-22g), wherein a writing area (26) is sequentially moved and positioned for defining the partial walls (22, 22'; 22a-22g), and wherein a partial wall (22, 22'; 22a-22g) is defined in the writing area (26).

## Revendications

1. Procédé de production d'une structure tridimensionnelle (10) dans un matériau lithographique (24) pouvant être polymérisé au moyen de procédés d'apport d'énergie et être ainsi durci, dans lequel une paroi superficielle (16) de la structure (10) à produire est d'abord polymérisée au moyen d'un premier procédé d'apport d'énergie à résolution spatiale de telle manière qu'un volume (28) est enfermé au niveau d'un matériau lithographique non polymérisé, dans lequel dans une étape de développement intermédiaire, du matériau lithographique (24) entourant la paroi superficielle (16) polymérisée est retiré, dans lequel le volume (28) enfermé grâce à la paroi superficielle (16) est polymérisé au moyen d'un second procédé d'apport d'énergie, dans lequel une structure de support (30) située à l'intérieur du volume (28) enfermé grâce à la paroi superficielle (16) est en outre définie au moyen du premier procédé d'apport d'énergie à résolution spatiale, **caractérisé en ce que**, dans le premier procédé d'apport d'énergie à résolution spatiale, la polymérisation du matériau lithographique est réalisée par absorption à deux photons ou par absorption à plusieurs photons dans une zone de focalisation spatialement déplaçable d'un faisceau d'écriture d'une source de rayonnement et dans lequel le second procédé d'apport d'énergie est différent du premier procédé d'apport d'énergie.

2. Procédé selon la revendication 1, **caractérisé en ce que** le second procédé d'apport d'énergie ne présente pas de résolution spatiale et/ou agit en totalité sur le matériau lithographique non polymérisé enfermé par la paroi superficielle (16).

3. Procédé selon l'une quelconque des revendications précédentes, **caractérisé en ce que** la structure de support (30) située à l'intérieur de la paroi superficielle (16) est définie de telle manière que la structure de support (30) présente des éléments de support s'étendant entre des sections de la paroi superficielle (16).

4. Procédé selon l'une quelconque des revendications précédentes, **caractérisé en ce que** le matériau lithographique est appliqué sur un substrat (14) et **en ce qu'**une section d'une surface (12) du substrat (14), ainsi que la paroi superficielle (16), enferme le volume (28) au niveau du matériau lithographique non polymérisé.

5. Procédé selon l'une quelconque des revendications précédentes, **caractérisé en ce que** l'étape de développement intermédiaire n'influe pas sur le volume (28) enfermé grâce à la paroi superficielle (16) au niveau du matériau lithographique non polymérisé.

6. Procédé selon l'une quelconque des revendications précédentes, **caractérisé en ce qu'**un matériau lithographique (24) photopolymérisable ou photopolymérisable et thermopolymérisable est utilisé.

7. Procédé selon l'une quelconque des revendications précédentes, **caractérisé en ce que** la paroi superficielle (16) présente plusieurs sections de paroi (22a à 22g) dotées d'épaisseurs de paroi différentes.

8. Procédé selon l'une quelconque des revendications précédentes, **caractérisé en ce que** la paroi superficielle (16) de la structure (10) à produire est définie en produisant de manière séquentielle une pluralité de sous-parois (22, 22'; 22a-22g), dans lequel une zone d'écriture (26) est déplacée et positionnée de manière séquentielle afin de définir les sous-parois (22, 22'; 22a à 22g), et dans lequel une sous-paroi (22, 22'; 22a à 22g) est respectivement définie dans la zone d'écriture (26) .
